# EUROPEAN PATENT APPLICATION

(11) **EP 4 471 876 A1**
(43) Date of publication of application: **04.12.2024**
(21) Application number: 23176102.4
(22) Date of filing: 30.05.2023
(51) Int. Cl.: H01L 31/041, H01L 31/042, H01L 31/048, H01L 31/05, H01L 31/02, B64G 1/44, H01L 23/60, H01L 31/0216

(54) **SOLAR CELL ASSEMBLY AND METHOD OF CONNECTING CONDUCTIVE COVER GLASSES OF THE SAME**

(71) Applicant: Airbus Defence and Space GmbH, 82024 Taufkirchen (DE)
(72) Inventor: Thomas, Andreev, 82024 Taufkirchen (DE)
(74) Representative: Schornack, Oliver

(57) **Abstract**

The invention relates to a solar cell assembly including a string of conductive cover glasses corresponding to a string of solar cells. The string of conductive cover glasses each have a top surface facing away with its conductive side from the respective solar cell. Conductive adhesives are disposed on the top surfaces of the conductive cover glasses. One or more connectors, such as wire conductors, are provided to connect the conductive adhesives such that the string of conductive cover glasses are connected in series. Thereby, the conductive cover glasses can be easily connected to each other and the grounding network of the solar cell assembly can be simplified.

## Description

### FIELD OF INVENTION

The present disclosure relates to a solar cell assembly. Particularly, the present disclosure relates to a solar cell assembly for space use and a method of connecting conductive cover glasses of the solar cell assembly.

### BACKGROUND ART

A solar cell assembly typically includes a cover glass disposed above a solar cell to protect the solar cell. For space use, standard very low conductive cover glasses would be charged up by bombardments of charged particles.

To avoid the build-up of charges, conductive cover glasses (such as Indium titanium oxide, ITO, glasses) are used as cover glasses. These conductive cover glasses exhibit a conductive surface for discharging the charges.

EP 2372784 A1 relates to a multi-junction solar cell with an amount of pn-junctions stacked on top of each other. Therein, a conductive or antistatic coating is provided at the cell edge (namely, the edge of a solar cell facing another solar cell) so as to connect the conductive surface of the cover glass on one side of the solar cell to the rear side metallization on the opposite side of the solar cell.

EP 2546889 A1 relates to a solar cell assembly of such solar cells and to a method of manufacturing a solar cell assembly. Therein, the cover glass of a solar cell is connected to a contact pad of an adjacent solar cell by a conductive adhesive, which attaches one end of an interconnector to the metallized sidewall of the cover glass. The other end of the interconnector is connected to the contact pad of the adjacent solar cell. Thereby, the cover glass of the solar cell can be grounded.

The conventional methods are, nonetheless, not ideal for connecting and grounding the conductive surfaces of the cover glasses. Specifically, the method of EP 2372784 A1 requires a mesa groove within the solar cell separating the active cell from the conductive or antistatic coating and thus additional space for the mesa groove between the solar cells. The method of EP 2546889 A1 utilizes an interconnector and contact pads on the solar cells for connecting the cover glasses and thus requires additional space and components on the solar cells. Therefore, in the conventional art, additional space and components in the solar cell are needed for connecting and grounding the conductive surfaces of the cover glasses. Such additional space and components, in turn, require complex and costly manufacturing processes. Moreover, since the grounding network in conventional art is connected to the sidewall or edge of the cover glass, the conventional methods have to deal with the risk of impacting the active cell area of the solar cell.

Therefore, there has been a problem of providing a simple, cost-efficient, and fast method for connecting the conductive cover glasses of the solar cell assembly for grounding.

### SUMMARY OF INVENTION

An object of the present disclosure is thus to provide a solar cell assembly with an improved connection for grounding the conductive cover glasses and a method of connecting the conductive cover glasses of a solar cell assembly. According to the present disclosure, a solar cell assembly and a method are set forth in independent claims. Preferred embodiments are defined in dependent claims.

In an aspect, the present disclosure provides a solar cell assembly comprising a first solar cell, a first conductive cover glass, a second solar cell, and a second conductive cover glass. The first conductive cover glass is disposed above the first solar cell and has a top surface facing away from the first solar cell. The second conductive cover glass is disposed above the second solar cell and has a top surface facing away from the second solar cell. A first conductive adhesive is disposed on the top surface of the first conductive cover glass and a second conductive adhesive is disposed on the top surface of the second conductive cover glass. A connector is provided to connect the first conductive adhesive to the second conductive adhesive. The connector may be a wire conductor, a rectangular wire, a metal strip, or a metal band, or the like.

By the solar cell assembly according to the present disclosure, the first and second conductive adhesives are disposed on the top surfaces of the respective cover glasses and then connected to each other by the connector. This avoids the risk of impacting the active cell areas of the solar cells that are normally exposed at the edge of the solar cells. A protection structure (such as a mesa groove) or an independent contact point for contact pads is no longer required for protecting the active cell areas at the edge of the solar cells. The structure of the solar cell assembly are thus simplified. Moreover, the process of applying conductive adhesives on the top surfaces is simple, fast, cost-efficient. A grounding network achieved by the solar cell assembly according to the present disclosure is thus more robust and safer against electrostatic discharge (ESD) and charge build up.

In some aspects, the first and second conductive adhesives may be directly attached to the top surfaces of the first and second conductive cover glasses, respectively. Thereby, the process of connecting the cover glasses is simplified.

In some aspects, the first conductive cover glass and the second conductive cover glass may be transparent conductive glasses. The transparent conductive glasses may be, at least partially, transmissive to the light to be absorbed by the solar cells. Preferably, the transparent conductive glasses may comprise Indium Tin oxide (ITO). The conductive cover glasses may be glasses coated with a conductive transparent material, such as an ITO coating. Thereby, each of the conductive cover glasses provides charge bleeding properties for preventing the build-up of charges if the cover glasses are grounded.

In some aspects, the solar cell assembly may include a string of solar cells connected in series and a string of conductive cover glasses corresponding to the string of solar cells. In some aspects, a plurality of solar cell assemblies are connected in series to form a string. The string of conductive cover glasses are each disposed above a respective solar cell of the string of solar cells and each have a top surface facing away from the respective solar cell. Conductive adhesives are provided on the top surfaces of the conductive cover glasses and one or more connectors are provided to connect the conductive adhesives such that the string of conductive cover glasses are connected in series. Thereby, the solar cell assembly includes a simple, cost-efficient, more robust, and safer grounding network for the string of cover glasses. The mass of the cover glass grounding network is also reduced. The one or more connectors may be wire conductors.

In some aspects, the string of conductive cover glasses may each have two conductive adhesives on the respective top surfaces. The one or more connectors may each have two ends disposed at one conductive cover glass and an adjacent conductive cover glass, respectively, wherein the one conductive cover glass and the adjacent conductive cover glass are adjacent to each other in the string of the conductive cover glasses. By providing two conductive adhesives on each conductive cover glass and one connector (such as a wire conductor) between two adjacent conductive cover glasses, the string can be easily connected by performing connection between two adjacent conductive cover glasses one at a time or all together, without affecting connection between other conductive cover glasses. It is thus possible to further simplify and expedite the process of connecting the string of conductive cover glasses. Further, the volume of adhesives for connection can be reduced by applying two conductive adhesives on each conductive cover glass, as compared to the volume of adhesives used to cover the solar cell edges. This further improves the safety of the solar cell assembly since the adhesives may deteriorate and crack due to, for example, normal or deep-temperature thermal cycling. Also the number of adhesive surface interface is low as there is only the cover glass to adhesive interface of potential criticality whereas the connector or wire conductor can be embedded partially or fully into the adhesive for additional safety.

In some aspects, the two conductive adhesives of the respective top surface may be disposed at two opposite sides along a direction of the string of the conductive cover glasses. Meanwhile, the two ends of the one or more connectors are fixed to conductive adhesives at respective sides of the adjacent conductive cover glass and the one conductive cover glass facing each other along the direction of the string of the conductive cover glass. Thereby, the connector extends between the sides of the two adjacent conductive cover glasses that are facing each other along the direction of the string of the conductive cover glasses. The length of the connector can thus be shortened, which not only simplifies the connection between two adjacent conductive cover glasses but also increases the space for simultaneously connecting multiple pairs of two adjacent conductive cover glasses.

In some aspects, the string of conductive cover glasses may have an end conductive cover glass at one end of the string. The top surface of the end conductive cover glass may be connected to a terminal by an end conductive adhesive on the top surface of the end conductive cover glass and an end connector connecting the end conductive adhesive to the terminal. The terminal may be adapted to be connected to ground. Thereby, the solar cell assembly may be easily connected to ground for achieving ESD safety by connecting the terminal to ground.

In some aspects, the end connector may be welded to the terminal.

In some aspects, the solar cell assembly may have a front side, on which the string of conductive cover glasses are disposed above the string of solar cells, and a rear side opposite to the front side. The terminal may be connected to the rear conductive cover glass on the rear side. The solar cell assembly may further include a cover glass bleeder resistor on the rear side.

In some aspects, the string of conductive cover glasses have another end conductive cover glass at the other end of the string. The top surface of the another end conductive cover glass may be connected to another terminal by another end conductive adhesive on the top surface of the another end conductive cover glass and another end connector connecting the another end conductive adhesive to the another terminal. The another terminal may be adapted to be connected to ground. Thereby, the solar cell assembly may be connected to ground from two sides. The grounding from two sides is a major advantage of the invention as the design is single point failure tolerant.

In another aspect, the present disclosure provides a method of connecting a string of conductive cover glasses of a solar cell assembly. The method includes providing conductive adhesives on top surfaces of the conductive cover glasses and connecting the conductive adhesives by one or more connectors. The top surfaces of the conductive cover glasses face away from solar cells disposed below the conductive cover glasses.

In some aspects, the conductive adhesives may be directly attached to the top surfaces of the conductive cover glasses in the step of providing conductive adhesives.

In some aspect, the string of conductive cover glasses may each have two conductive adhesives disposed on the respective top surfaces. The one or more connectors may each have two ends disposed on one conductive cover glass and an adjacent conductive cover glass, respectively. The adjacent conductive cover glass and the one conductive cover glass are adjacent to each other in the string of conductive cover glasses.

### Brief Description of Drawings

In the drawings, which are not necessarily drawn to scale, like numerals may reference similar components in different figures. The shapes of elements illustrated in the drawings are not intended to limit the embodiments or the scope of the present disclosure, unless explicitly specified. The drawings illustrate various embodiments of the present disclosure.
Fig. 1 is a diagram illustrating a top view of a portion of a solar cell assembly according to the present disclosure.
Fig. 2 is a diagram illustrating an enlarged view of the area C in Fig. 1.
Fig. 3 is a diagram illustrating the grounding network of the solar cell assembly according to the present disclosure.
Fig. 4 is a diagram illustrating a cover glass bleed resistor on the panel rear side with wire connections.
Fig. 5 is a diagram illustrating a flowchart of a method according to the present disclosure.

### Detailed Description

In the present disclosure, when an element, such as a layer, a region, or a substrate, is referred to as being on, connected to, connected to, coupled to, or attached to another element, it may be directly on, connected, coupled, or attached to the other element, or one or more intervening elements may be present. In contrast, when an element is referred to as being directly on, directly connected to, directly coupled to, or directly attached to another element or layer, there are no intervening elements or layers present. Although the terms directly on, directly connected to, directly coupled to, or directly attached to may not be used throughout the detailed description, elements that are shown (e.g., in the drawings) as being directly on, directly connected, directly coupled, or directly attached can be referred to as such.

Spatially relative terms (e.g., on, before, top, bottom, and so forth) are intended to encompass different orientations of the device in use or operation in addition to the orientation depicted in the figures and to be interpreted together with the relevant context.

The term solar cell assembly denotes a spatial arrangement of a plurality of solar cells or cover integrated cells, i.e. solar cells equipped with interconnector and cover glass.

Embodiments according to the present disclosure will be explained in the following with reference to the figures.

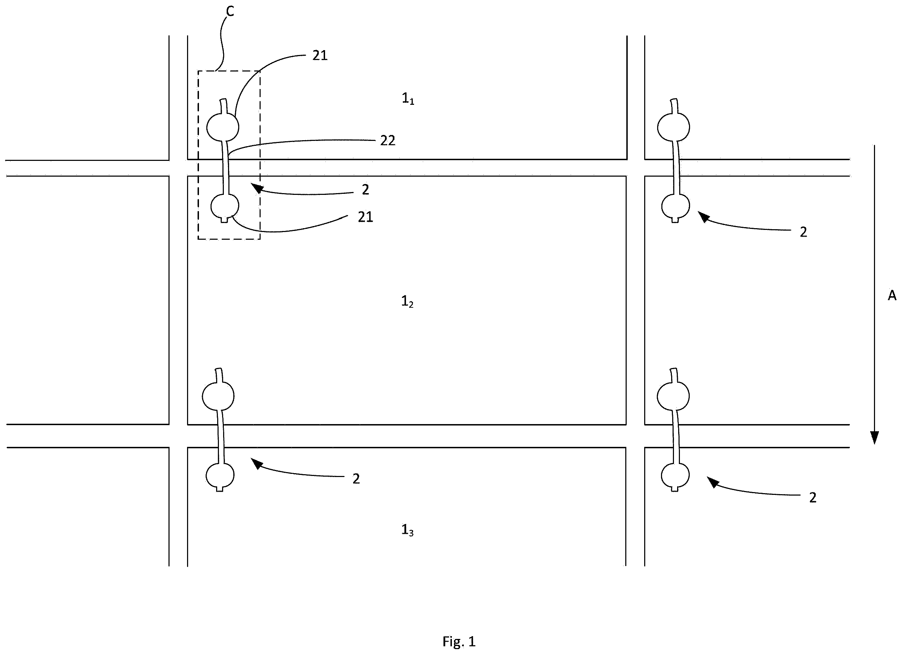

Fig. 1 illustrates a top view of a portion of a solar cell assembly. In the middle of Fig. 1, three conductive cover glasses 1₁ to 1₃ are illustrated. The three conductive cover glasses 1₁ to 1₃ forms a string of conductive cover glasses or forms a part of a string of conductive cover glasses in a direction A. On the left and right sides of the three conductive cover glasses 1₁ to 1₃, the solar cell assembly also includes a left string of conductive cover glasses and a right string of conductive cover glasses in the direction A. Each of the conductive cover glasses has a top surface, which is conductive, as shown in the top view. As can be seen in Fig. 1, the conductive cover glasses are spaced from each other by a gap.

Through not illustrated in the drawings, the solar cell assembly has solar cells corresponding to conductive cover glasses, respectively. Specifically, the conductive cover glasses are disposed above the respective solar cells in the direction normal to the top surface for protecting the respective solar cells. More specifically, the solar cell assembly has strings of solar cells and strings of conductive cover glasses. Each string of conductive cover glasses connected in series may be disposed above a string of solar cells connected in series so that the conductive cover glasses face the solar cells, respectively. In some embodiments, different strings of conductive cover glasses can be connected for simplifying the manufacturing process, which also shows the flexibility of the solar cell assembly according to the present disclosure.

The conductive cover glasses may be transparent conductive glasses, which are, at least partially, transmissive to the light to be absorbed by the solar cells disposed below the conductive. Preferably, the transparent conductive cover glasses comprise Indium Tin oxide (ITO). The conductive cover glasses may be glasses coated with a conductive transparent material, such as an ITO coating. Thereby, each of the conductive cover glasses provides charge bleeding properties for preventing the build-up of charges resulting from charged particles in space.

Referring again to Fig. 1, the adjacent two conductive cover glasses in a string of conductive cover glasses are connected to each other through their top surfaces. In Fig. 1, the first conductive cover glass 1₁ is connected to the second conductive cover glass 1₂, which is then connected to the third conductive cover glass 1₃ to form a string or a part of a string of conductive cover glasses. As can be seen on the right side of the first, second, and third conductive cover glasses 1₁, 1₂, 1₃ in Fig. 1, three conductive cover glasses are also connected in series to form a string or a part of a string of conductive cover glasses.

Specifically, two adjacent conductive cover glasses in a string are connected to each other by a connector 2. The connector 2 includes a wire conductor 22 (as a connector) connecting two conductive adhesives 21 disposed on the top surfaces of the two adjacent cover glasses. The wire conductor according to the present disclosure may comply with American Wire Gauge (AWG) 40, or other sizes. The conductive adhesives according to the present disclosure may be the conductor under the tradename NuSil CV1500.

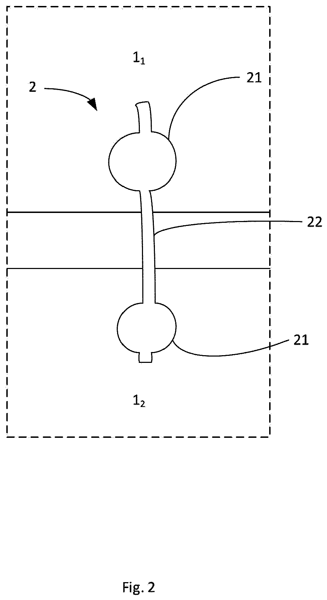

Referring to Fig. 2, which illustrates an enlarged view of the area C in Fig. 1, the conductive adhesives 21 are disposed on the top surfaces of the first conductive cover glass 1₁ and the second conductive cover glass 1₂. In particular, the conductive adhesives 21 are directly applied onto the top surfaces of the first conductive cover glass 1₁ and the second conductive cover glass 1₂. A wire conductor 22 is then attached (and/or embedded partly or fully into) to the conductive adhesives 21. Thereafter, the conductive adhesives 21 are cured and fixed, together with the wire conductor 22, on the top surfaces of the first conductive cover glass 1₁ and the second conductive cover glass 1₂. The connector 2 is thus formed of the wire conductor and the two conductive adhesives 21 on the first conductive cover glass 1₁ and the second conductive cover glass 1₂.

As a result, an electrical connection is accomplished between the first conductive cover glass 1₁ and the second conductive cover glass 1₂. In other words, the first conductive cover glass 1₁ is electrically connected to the second conductive cover glass 1₂ by the connector 2.

Referring to Fig. 1 again, a connector 2 is provided to connect the second conductive cover glass 1₂ to the third conductive cover glass 1₃. The first, second, and third conductive cover glasses 1₁, 1₂, 1₃ are thereby connected in series to form a string or a part of a string of conductive cover glasses in the direction A. The same applies to the right string and the left string of conductive cover glasses in Fig. 1.

By connecting the conductive cover glasses through their top surfaces according to the present disclosure, the conductive cover glasses can be easily connected to each other for grounding. This avoids the risk of impacting the active cell areas of the solar cells that are normally exposed at the edge of the solar cells. The process of connecting the conductive cover glasses can also be simplified, faster and more cost-efficient, since the top surfaces of the conductive cover glasses offer a large area of implementing the connection and protection for the active cells below the conductive cover glasses. A grounding network of the solar cell assembly according to the present disclosure is thus more robust and safer against electrostatic discharge (ESD), and allows for charge reduction.

As shown in Fig. 1, each conductive cover glass has two conductive adhesives 21 on its top surface, one for connection with an upstream conductive cover glass in the direction A and the other for connection with a downstream conductive cover glass in the direction A. As also shown in Fig. 1, each wire conductor 22 has two ends on one conductive cover glass and an adjacent conductive cover glass, respectively. For example, two ends of a wire conductor 22 are disposed at the first conductive cover glass 1₁ and the second conductive cover glass 1₂, respectively.

By providing two conductive adhesives on each conductive cover glass and one wire conductor between two adjacent conductive cover glasses, the string can be easily connected by performing connection between two adjacent conductive cover glasses one at a time or all together, without affecting connection between other conductive cover glasses. For example, the connector 2 between the first conductive cover glass 1₁ and the second conductive cover glass 1₂ and the connector 2 between the second conductive cover glass 1₂ and the third conductive cover glass 1₃ can be prepared at the same time without affecting each other. It is thus possible to further simplify and expedite the process of connecting the string of conductive cover glass.

In particular, the two conductive adhesives 21 on the same conductive cover glass are provided at two opposite sides along the direction A of the string of the conductive cover glasses. The wire conductor 22 is fixed to two conductive adhesives 21 at respective sides of two adjacent conductive cover glasses facing each other along the direction A of the string. More specifically, in Fig. 1, the upper side of the second conductive cover glass 1₂ along the direction A faces the lower side of the first conductive cover glass 1₁. The wire connector 22 is fixed to two conductive adhesives 21 at the upper side of the second conductive cover glass 1₂ and the lower side of the first conductive cover glass 1₁, respectively.

By fixing the wire conductor at respective sides of two adjacent conductive cover glasses facing each other, the length of the wire conductor can be further shortened, which not only simplifies the connection between two adjacent conductive cover glasses but also increases the space for simultaneously connecting multiple pairs of two adjacent conductive cover glasses.

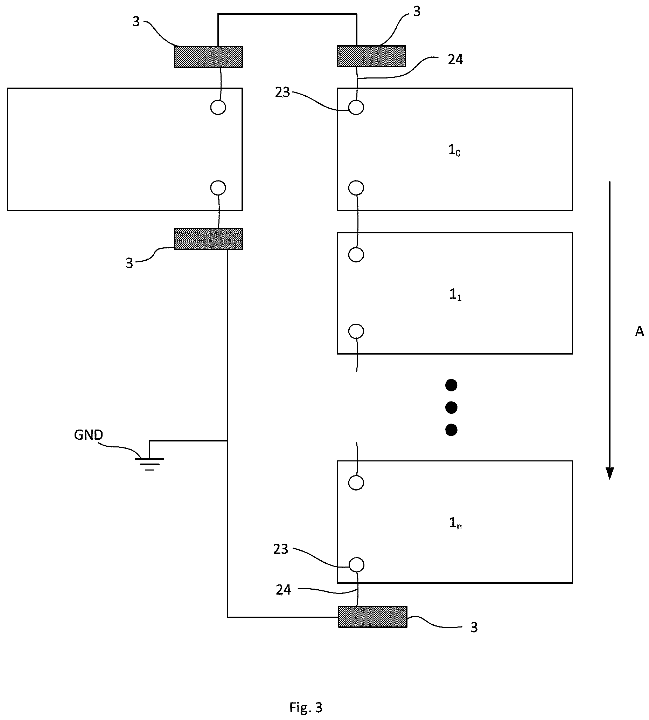

Referring to Fig. 3, a grounding network of the solar cell assembly according to the present disclosure will be explained in the following.

A string of conductive cover glasses 1₀ to 1ₙ is illustrated in Fig. 3. The string has an end conductive cover glass 1₀ at one end and another end conductive cover glass 1ₙ at the other end. On the top surface of the end conductive cover glass 1₀, an end conductive adhesive 23 provided at the upper side is connected by an end wire conductor 24 (as an end connector) to a (small) terminal 3. The terminal 3 can then be connected to ground. In Fig. 3, the terminal 3 next to the end conductive cover glass 1₀ is connected to an optional cover glass bleeder resistor on the panel rear side.

At the other end of the string, another end conductive adhesive 23 provided at the lower side of the another end conductive cover glass 1ₙ is connected to another terminal 3 by another end wire conductor 24 (as another end connector). The another terminal 3 can then be connected to ground. Thereby, the solar cell assembly may be connected to ground from two sides of the string. The grounding from two sides is a major advantage of the invention as the design is single point failure tolerant.

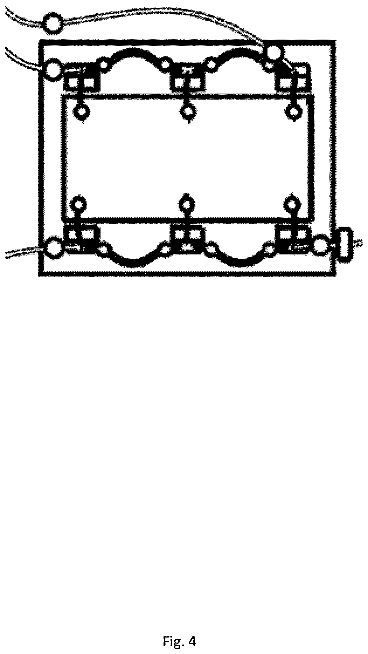

Referring to Fig. 4, a cover glass bleed resistor is provided on the panel rear side with wire connections. The cover glass bleed resistor is located on and glued to the back/rear side of the solar cell assembly. The cover glass bleed resistor has several glue points and welding terminals for providing redundancy. By providing such cover glass bleed resistor, no high-standard and expensive components (such as EEE parts) are required for grounding the solar cell assembly. The cover glass bleed resistor is also more robust and provides bleeding the string ends on the front side of the solar cell assembly. Further, the cover glass bleed resistor can ground or soft ground other components. The cover glass bleed resistor can be located onto the panel rear side to safe place on the panel front side for solar cells. The connection is realized by standard solar array wires (with electrical insulation). These wires are welded on one side to a welding terminal of the cover glass bleed resistor and on the other side to the welding terminals of the cover glass string ends. This can be done in redundant ways.

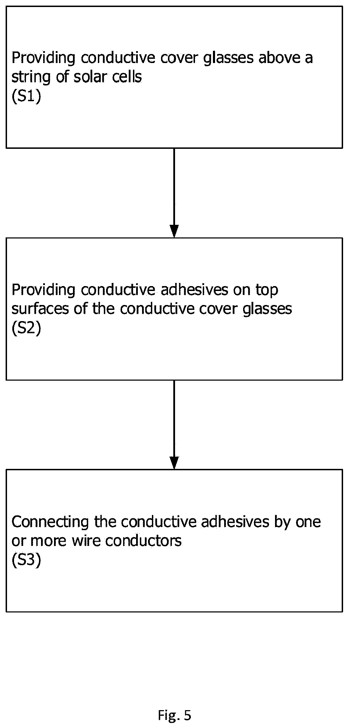

A method of connecting a string of conductive cover glasses of a solar cell assembly will be described in the following with reference to Fig. 5.

In step S1, conductive cover glasses are provided above a string of solar cells in the solar cell assembly. The process of preparing conductive cover glasses can be done by any methods in the conventional art.

In step S2, conductive adhesives are provided on top surfaces of the conductive cover glasses. Preferably, each conductive cover glass is provided with two conductive adhesives at two opposite sides on its top surface along the direction of the string (as illustrated in Fig. 1). The conductive adhesives may be directly attached to the top surfaces.

In step S3, one or more connectors (such as wire conductors) are provided to connect the conductive adhesives such that the conductive cover glasses are connected in series to form a string of conductive cover glasses. Preferably, each pair of two adjacent conductive cover glasses is provided with a separate connector. Namely, each connector has two ends disposed at two adjacent conductive cover glasses, respectively. The conductive adhesives may be directly attached to the top surfaces of the conductive cover glasses.

As a result, the conductive cover glasses are connected in series by the conductive adhesives and the one or more connectors.

The method may include repeating the steps S2 and S3 once for each pair of adjacent conductive cover glasses or repeating the steps S2 and S3 once for a plurality of pairs of adjacent conductive cover glasses. The method may also perform the step S2 for all of the conductive cover glasses before performing the step S3 for all of the conductive adhesives.

While specific embodiments are described above with reference to the drawings, various modifications are covered by the present disclosure. In the following, some modifications of the present disclosure will be described by discussing the differences from the embodiments described above.

In one modification, the conductive adhesives may be formed of different shapes than the circular shapes illustrated in Figs. 1 to 4.

In one modification, the conductive adhesives connected by a connector may be formed of different shapes. Thereby, the direction of the string may be easily recognized.

In one modification, the conductive adhesive at an end of the string (namely, end conductive adhesive 23) may have a different shape than the remaining conductive adhesives in the string. Thereby, the end conductive adhesive 23 for connection to a terminal and ground can be easily recognized.

In one modification, the connectors may be a rectangular wire, a metal strip, a metal band, or the like for connecting one conductive adhesive to another conductive adhesive or to a terminal.

The above embodiments and modifications are not intended to limit the scope of the present invention. Various implementations are covered by the scope of the present invention defined by the appended claims.

The above describes some aspects or elements of the solar cell assembly, with which the present disclosure is concerned. A person skilled in the art would understand from the common general knowledge that the solar cell assembly may include other aspects or elements (such as antireflection coating, texturing of surfaces, encapsulation, etc.) for implementation of a solar cell assembly.

## Claims

1. A solar cell assembly, comprising
a first solar cell,
a first conductive cover glass (1₁) disposed above the first solar cell and having a top surface facing away from the first solar cell,
a first conductive adhesive (21) on the top surface of the first conductive cover glass (1₁),
a second solar cell,
a second conductive cover glass (1₂) disposed above the second solar cell and having a top surface facing away from the second solar cell,
a second conductive adhesive (21) on the top surface of the second conductive cover glass (1₂), and
a connector (22) connecting the first conductive adhesive to the second conductive adhesive.

2. The solar cell assembly according to claim 1, wherein the first and second conductive adhesives (21) are directly attached to the top surfaces of the first and second conductive cover glasses (1₁, 1₂), respectively.

3. The solar cell assembly according to claim 1 or 2, wherein the first conductive cover glass (1₁) and the second conductive cover glass (1₂) are transparent conductive glasses and/or comprise Indium Tin oxide, ITO.

4. The solar cell assembly according to any of claims 1 to 3, the connector (22) is a wire conductor connecting the first conductive adhesive to the second conductive adhesive.

5. The solar cell assembly according to any of claims 1 to 4, further comprising:
a string of solar cells connected in series and including the first and second solar cells,
a string of conductive cover glasses (1₀ to 1ₙ) including the first and second conductive cover glasses (1₁, 1₂), each of the conductive cover glasses (1₀ to 1ₙ) being disposed above a respective solar cell of the string of solar cells and having a top surface facing away from the respective solar cell,
conductive adhesives (21) on the top surfaces of the conductive cover glasses (1₀ to 1ₙ),
one or more connectors (22) connecting the conductive adhesives (21) such that the string of conductive cover glasses (1₀ to 1ₙ) are connected in series.

6. The solar cell assembly according to claim 5,
wherein the string of conductive cover glasses (1₀ to 1ₙ) each have two conductive adhesives (21) on the respective top surfaces,
wherein the one or more connectors (22) each have two ends disposed at one conductive cover glass and an adjacent conductive cover glass, respectively, and
wherein the adjacent conductive cover glass and the one conductive cover glass are adjacent to each other in the string of conductive cover glasses (1₀ to 1ₙ).

7. The solar cell assembly according to claim 6,
wherein the two conductive adhesives (21) on the respective top surface are disposed at two opposite sides along a direction (A) of the string of the conductive cover glasses (1₀ to 1ₙ), and
wherein the two ends of the one or more connectors (22) are fixed to conductive adhesives (21) at respective sides of the adjacent conductive cover glass and the one conductive cover glass facing each other along the direction (A) of the string of the conductive cover glasses (1₀ to 1ₙ).

8. The solar cell assembly according to any of claims 5 to 7,
wherein the string of conductive cover glasses (1₀ to 1ₙ) have an end conductive cover glass (1₀) at one end of the string,
wherein the top surface of the end conductive cover glass (1₀) is connected to a terminal (3) by an end conductive adhesive (23) on the top surface of the end conductive cover glass (1₀) and an end connectors(24) connecting the end conductive adhesive (23) to the terminal (3), and
wherein the terminal (3) is adapted to be connected to ground (GND).

9. The solar cell assembly according to claim 8, wherein the end connectors (24) is welded to the terminal (3).

10. The solar cell assembly according to claim 8 or 9,
wherein the solar cell assembly has a front side, on which the string of conductive cover glasses are disposed above the string of solar cells, and a rear side opposite to the front side, and
wherein the terminal (3) is connected to a rear conductive cover glass on the rear side.

11. The solar cell assembly according to claim 10, further comprising a cover glass bleeder resistor on the rear side.

12. The solar cell assembly according to any of claim 8 to 11,
wherein the string of conductive cover glasses have another end conductive cover glass (1ₙ) at the other end of the string,
wherein the top surface of the another end conductive cover glass (1ₙ) is connected to another terminal (3) by another end conductive adhesive (23) on the top surface of the another end conductive cover glass (1ₙ) and another end connectors (24) connecting the another end conductive adhesive (23) to the another terminal (3),
wherein the another terminal (3) is adapted to be connected to ground (GND).

13. A method of connecting conductive cover glasses of a solar cell assembly into a string, comprising
providing conductive adhesives on top surfaces of the conductive cover glasses, wherein the top surfaces of the conductive cover glasses face away from solar cells disposed below the conductive cover glasses, and
connecting the conductive adhesives by one or more connectors.

14. The method according to claim 13, wherein the conductive adhesives are directly attached to the top surfaces of the conductive cover glasses.

15. The method according to claim 13 or 14,
wherein the string of conductive cover glasses each have two conductive adhesives disposed on the respective top surfaces, and
wherein the one or more connectors each have two ends disposed on one conductive cover glass and an adjacent conductive cover glass, respectively,
wherein the adjacent conductive cover glass and the one conductive cover glass are adjacent to each other in the string of conductive cover glasses.
